# EUROPÄISCHE PATENTSCHRIFT

(11) **EP 1 730 331 B1**
(45) Veröffentlichungstag und Bekanntmachung des Hinweises auf die Patenterteilung: **22.05.2013**
(21) Anmeldenummer: 05743152.0
(22) Anmeldetag: 11.03.2005
(51) Int. Cl.: C30B 15/30

(54) **KRISTALLZIEHANLGE MIT EINEM SEILDREHKOPF UND SEILDREHKOPF FUER EINE KRISTALLZIEHANLAGE**
CRYSTAL PULLING SYSTEM WITH A ROTATING CABLE HEAD AND A ROTATING CABLE HEAD FOR A CRYSTAL DRAWING SYSTEM
INSTALLATION DE TIRAGE DE CRISTEAUX AVEC UN TETE ROTATIVE POUR CABLE ET TETE ROTATIVE DE CABLE CONCUE POUR UNE INSTALLATION DE TIRAGE DE CRISTAUX

(30) Priorität: 11.03.2004 DE 102004011901
(43) Veröffentlichungstag der Anmeldung: 13.12.2006
(73) Patentinhaber: PVA TePla AG, 35435 Wettenberg (DE)
(72) Erfinder: MÜHE, Andreas, 63452 Hanau (DE)
(74) Vertreter: Hebing, Norbert
(86) Internationale Anmeldenummer: PCT/DE2005/000461
(87) Internationale Veröffentlichungsnummer: WO 2005/087985

(56) Entgegenhaltungen:
- DE-A1- 19 932 026
- US-A- 4 190 630
- US-A- 4 367 199

## Beschreibung

Die Erfindung bezieht sich auf eine Kristallziehanlage mit einem Seildrehkopf für eine Kristallziehanlage, der mittels eines an der Kristallziehanlage ortsfest angeordneten Rotationsmotors um eine vertikale Drehachse drehbar ist, wobei im Seildrehkopf ein von einem Ziehmotor über ein Getriebe angetriebener Seilwickelmechanismus installiert ist, mit dem ein in der vertikalen Achse hängendes Ziehseil vertikal bewegbar ist.

Die Erfindung bezieht sich weiterhin auf einen Seildrehkopf für eine Kristallziehanlage.

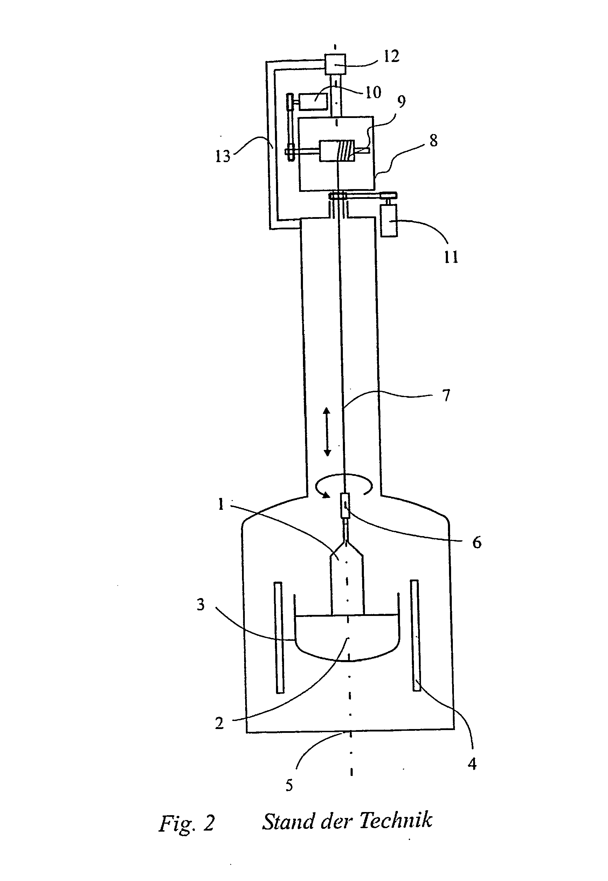

Ein solcher, in einer Czochralski-Kristallziehanlage eingesetzter Seildrehkopf mit einem Seilwickelmechanismus ist in der DE 100 07 265, DE 43 29 283, EP 437 775 bzw. US 436 71 99 beschrieben. Zum Stand der Technik sind außerdem zu nennen: US 4 190 630 A und die gattungsgemäße DE 199 32 026 A1. Zur folgenden, näheren Erläuterung des Standes der Technik wird auf die Fig. 2 Bezug genommen. Dort ist ein Seilwickelmechanismus schematisch dargestellt. Eine solche Anlage wird verwendet, um einen Kristall 1, beispielsweise einen Silizium-Einkristall, aus einer Schmelze 2, beispielsweise einer Silizium-Schmelze, welche sich in einem Tiegel 3, beispielsweise einem Quarzglastiegel, befindet, nach oben zu ziehen. Der Tiegel mit der Schmelze wird durch eine Heizeinrichtung 4, beispielsweise eine elektrische widerstandsheizung oder eine Induktionsheizung, beheizt. Der Züchtungsraum wird von einer Prozesskammer 5 eingeschlossen, die bei Bedarf evakuiert oder mit Schutzgas befüllt oder gespült werden kann.

Der Kristall hängt an einem Keimkristallhalter 6, welcher seinerseits an einem Ziehseil 7, beispielsweise einem Edelstahlseil oder einem Wolframseil, befestigt ist. Zu Beginn der Kristallzüchtung wird zunächst der Keimkristallhalter 6 abgesenkt und der Keimkristall mit der Schmelze 2 in Kontakt gebracht. Anschließend wird der Keimkristallhalter 6 langsam und kontrolliert wieder angehoben, so dass an dem Keimkristall weiteres Material aus der Schmelze mit der Geschwindigkeit kristallisiert, mit der der Keimkristallhalter nach oben gezogen wird. Ein Absinken des Schmelzniveaus im Tiegel 3 wird oft durch ein langsames Anheben des Tiegels 3 kompensiert. Um einen annähernd zylindrischen Kristall 1 zu erhalten, werden während der Kristallzüchtung meist sowohl der Kristall 1 als auch der Tiegel 3 in Rotation um ihre vertikale Achse versetzt. Aufgrund dieser Prozessführung kommt dem sogenannten Seildrehkopf 8 die Aufgabe zu, das Ziehseil 7 sowohl sehr präzise heben und senken als auch in Rotation versetzen zu können. Dies wird durch eine Seiltrommel 9 gelöst, die über ein Getriebe und einen Ziehmotor 10 in Rotation versetzt werden kann und dadurch das Ziehseil 7 auf- oder abwickelt. Die Seiltrommel 9 befindet sich mitsamt ihrem Antrieb in einem Gehäuse oder auf einer Plattform, welche mittels eines Rotationsmotors 11 in Rotation um die vertikale Achse der Ziehanlage versetzt werden kann. Aufgrund der Rotation des Ziehantriebs um die vertikale Achse der Ziehanlage müssen die Verbindungskabel des Ziehmotors 10 über Schleifringe 12 angeschlossen werden, deren relativ zur Anlage nicht rotierender Anschluss durch einen Halter und Kabelkanal 13 mit der Ziehanlage verbunden ist.

Die im Stand der Technik dokumentierte Ausführung eines Seildrehkopfes, bei dem der Ziehmotor 10 gemeinsam mit der Seiltrommel 9 um die vertikale Achse der Ziehanlage rotiert, hat den Nachteil, dass ein Anschluss des Ziehmotors 10 zur elektrischen Energieversorgung sowie zum Erfassen der Motordrehzahl und damit der Hubgeschwindigkeit nur über Schleifringe 12 erfolgen kann. Solche Schleifringe basieren auf einem reibenden elektrischen Kontakt zwischen einem rotierenden und einem ruhenden Polelement, wobei einerseits ein Verschleiß der Polelemente unvermeidlich ist und andererseits Störungen der über die Schleifringe übertragenen elektrischen Signale auftreten können. Deshalb werden in heute bekannten Seildrehköpfen digitale Motorsteuerungseinheiten unmittelbar in den rotierenden Teil des Seildrehkopfes mit eingebaut, so dass über die Schleifringe nur noch digitale Datenbus-Signale und die Versorgungsspannung übertragen werden. Dies führt jedoch zu einer sehr großen Bauform und einer großen rotierenden Masse, kombiniert mit möglichen Problemen aufgrund einer Unwucht des rotierenden Teils des Seildrehkopfes. Auch das Problem der Verschleißerscheinungen und die damit verbundene Notwendigkeit der Wartung der Schleifringe 12 kann so nicht gelöst werden.

In DE 199 32 026 sind die genannten Probleme der Energie-und Signalübertragung in den rotierenden Teil des Seildrehkopfes durch eine induktive Einkopplung elektrischer Energie und elektrischer Signale von einer ruhenden Induktionsspule in einer koaxial angeordneten und mit dem Seildrehkopf rotierenden Induktionsspule gelöst. Alternativ wird nur die elektrische Energie auf induktivem Wege in den Seildrehkopf übertragen, während die Signalkommunikation durch eine optische Ubertragungsstrecke oder eine Hochfrequenz-Ubertragungsstrecke erfolgt. Dadurch kann auf Schleifringe vollständig verzichtet und sowohl das Verschleißproblem als auch das Problem der Störungsfreiheit der übertragenen Signale gelöst werden. Allerdings ist diese Lösung mit einem hohen technischen Aufwand, insbesondere bei der Verwirklichung der Datenübertragung, und deshalb mit hohen Kosten verbunden.

Die Erfindung beruht somit auf der Aufgabe, einen einfach aufgebauten und kostengünstig zu realisierenden Seildrehkopf sowie eine Kristallziehanlage mit einem derartigen Seildrehkopf zu schaffen, bei dem die oben erwähnten Probleme nicht auftreten.

Gemäß der Erfindung wird die Aufgabe mit einer Kristallziehanlage mit einem Seildrehkopf gemäß dem oberbegriff des Anspruches 1 gelöst, der die weiteren Merkmale aufweist, dass der Ziehmotor ebenfalls an der Kristallziehanlage ortsfest angeordnet ist und dass das Getriebe zwischen dem ziehmotor und dem Seilaufwickelmechanismus ein Übertragungsglied aufweist, dessen Drehachse mit der vertikalen Drehachse des Seildrehkopfes übereinstimmt.

Der Clou der Erfindung besteht somit darin, dass das in der vertikalen Achse angeordnete Übertragungsglied seine Position auch bei einer Drehung des Seildrehkopfes beibehält, so dass die weiteren Glieder des Getriebes unabhängig von der winkellage des Seildrehkopfes mit dem Übertragungsglied gekoppelt bleiben. Dies ermöglicht es, den Ziehmotor ortsfest anzuordnen, was den Vorteil hat, dass die elektrischen Zuleitungen für die Energieversorgung und für die Übertragung der steuersignale konventionell mit der Anlagensteuerung verbunden werden können. Insbesondere entfällt die Notwendigkeit der Verwendung von Schleifringen und der damit verbundenen aufwändigen und teuren Maßnahmen zur Vermeidung elektrischer Störungen sowie dem damit verbundenen wartungsaufwand. Zugleich kann der erfindungsgemäße Seildrehkopf sehr kompakt gebaut werden und bedarf auch keiner technologisch aufwändigen, induktiven Energie- und Signalübertragung.

Bei einer solche Anordnung des Übertragungsgliedes muss allerdings beachtet werden, dass bei einem sich drehenden Seildrehkopf sich das auf das Übertragungsglied folgende Glied des Getriebes am Übertragungsglied abwickelt und dadurch einen Antrieb der Seilzuganlage und damit einen Hub der Ziehseiles induziert. Dies kann durch eine wieterentwicklung der Erfindung verhindert werden, wonach eine Anlagensteuerung vorgesehen ist, die die Antriebsbewegung des Ziehmotors so einstellt, dass der durch eine Drehung des Seildrehkopfes induzierte Antrieb des Seilaufwickelmechnismus und die damit verknüpfte vertikale Bewegung des Ziehseiles kompensiert wird und eine der Anlagensteuerung mitgeteilte Hubgeschwindigkeit des Ziehseiles erreicht wird.

Die für die Steuerung benötigten Informationen werden durch Inkrementalgeber erhalten, mit denen beide Motoren gekoppelt sind.

Üblicherweise wird das Ziehseil durch eine Hohlwelle geführt, die den Seildrehkopf trägt. Bei einer solche Anordnung lässt sich das Übertragungsglied am besten drehbar auf der Hohlwelle lagern. Damit können auch die beiden Motoren unterhalb des Seildrehkopfes auf dem Kopf der Kristallzüchtungsanlage angeordnet werden, was zu einem kompakten Aufbau führt.

Ein einfache Ausführung des Übertragungsgliedes ist ein Doppelzahnrad mit zwei übereinanderliegenden Verzahnungen, wobei das unter Zahnrad mit der Ausgangswelle des Ziehmotors und das obere Zahnrad mit Antriebswelle des Seilaufwickelmechnismus gekoppelt ist.

Große Gestaltungsfreiheit in der Anordnung des Ziehmotors und des Getriebes erhält man, wenn die Antriebsverbindung des Zahnrades mit der Ausgangswelle bzw. mit der Antriebswelle jeweils einen Zahnriemen aufweist.

Die oben erwähnte Steuerung der Motoren kann verbessert werden, wenn wenigstens ein Positionssensor zur Bestimmung des Seilhubes vorgesehen ist

Bei eine Kristallzüchtungsanlage ist am Ende des Ziehseils ein Keimkristallhalter vorgesehen. Dabei kann der Positionssensor als Positionsendschalter in der höchsten Position des Halters ausgebildet sein.

Die Anlagensteuerung ist dabei so eingerichtet, dass sie ausgehend von dieser höchsten Position des Halters, deren Erreichen mittels des Positionsendschalters festgestellt wird, und den Signalen der Inkrementalgeber den jeweils aktuellen Hub des Halters zu ermitteln vermag.

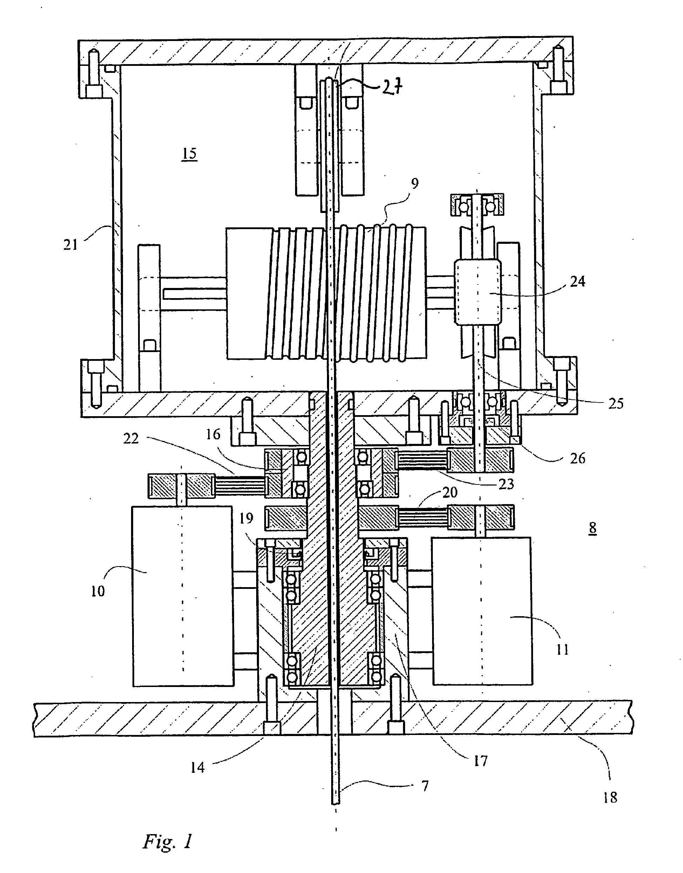

Ein Ausführungsbeispiel der Erfindung soll anhand von Fig. 1 näher beschrieben werden.

Soweit Elemente aus dem Stand der Technik, die anhand der Figur 2 beschrieben sind, auch in der Darstellung der Fig. 1 vorhanden sind, wird auf das oben Gesagte verwiesen.

Gemäß Fig. 1 ist eine Hohlwelle 14 über eine konventionell ausgeführte drehbare Lagerung 17 mit der oberen Abdeckung der Schleusenkammer 18 der Kristallziehanlage verbunden. Eine vakuumdichte Wellendurchführung 19, beispielsweise mittels eines Radialwellendichtringes oder einer ferrofluidischen Dichtung, trennt die Atmosphäre im Inneren der Kristallziehanlage von der Umgebungsatmosphäre. Die Hohlwelle 14 wird über einen Zahnriemen 20 von einem als Rotationsmotor 11 bezeichneten Motor, beispielsweise einem drehzahlgeregelten Servomotor, angetrieben.

Auf der Hohlwelle 14 ist der Seilwickelmechanismus 15 befestigt, der in einem vakuumdichten, zylindrischen Gehäuse 21 eingebaut ist. Die Hohlwelle 14 ist von einem ebenfalls als Hohlwelle ausgeführten Zahnrad 16 koaxial umgeben, das gegenüber der erstgenannten Hohlwelle 14 drehbar gelagert ist. Das Doppelzahnrad 16 wird über einen Zahnriemen 22 von einem als Ziehmotor 10 bezeichneten Motor, beispielsweise einem drehzahlgeregelten Servomotor, angetrieben. Gleichzeitig überträgt das Doppelzahnrad 16 über einen Zahnriemen 23 mechanische Energie auf den Seilwickelmechanismus 15, wenn es durch den Ziehmotor 10 mit einer bestimmten Drehzahl bewegt wird, die von der Drehzahl der Hohlwelle 14 abweicht.

Der Seilwickelmechanismus 15 besteht aus einer horizontal angeordneten Seiltrommel 9, die über ein Schneckenradgetriebe 24 von einer Hilfswelle 25 angetrieben wird, welche ihrerseits über den Zahnriemen 23 von dem Doppelzahnrad 16 angetrieben wird. Die Hilfswelle 25 kann durch eine vakuumdichte Wellendurchführung 26, beispielsweise mittels eines Radialwellendichtringes oder einer ferrofluidischen Dichtung in das vakuumdichte, zylindrische Gehäuse 21 geführt werden. Anstelle der Zahnriemen 20, 22, 23 kann jeweils auch ein Zahnradgetriebe verwendet werden.

Das von der Seiltrommel 9 ablaufende Ziehseil 7 kann über eine Umlenkrolle 27 geführt werden, um eine verbesserte Zentrierung und Justierbarkeit des Eintrittspunktes des Ziehseils 7 in die Kristallziehanlage zu erreichen. Die Seiltrommel 9 kann aber auch vertikal angeordnet und selbst über einen Zahnriemen oder ein Zahnradgetriebe angetrieben werden, wobei dann mindestens eine Umlenkrolle erforderlich wird, um das in einer horizontalen Ebene von der Seiltrommel 9 ablaufende Ziehseil 7 in die vertikale Richtung umzulenken.

Zur Einstellung der Seildrehzahl, also der Drehzahl, mit der sich das Ziehseil um die vertikale Achse dreht, ist bei der beschriebenen Ausführung nur die Motordrehzahl des Rotationsmotors 11 und die Übersetzung des Zahnriemens 20 zu berücksichtigen. Zur Einstellung der Hub- bzw. Absenkgeschwindigkeit des Ziehseiles 7 ist neben der Drehzahldifferenz der Hohlwellen (Hohlwelle 14, Doppelzahnrad 16) die Übersetzung des Zahnriemens 23, die Übersetzung des Schneckenradgetriebes 24 sowie der Umfang der Seiltrommel 9 zu berücksichtigen.

Zur Bestimmung der Drehzahldifferenz der Hohlwellen 14, 16 sind die Motordrehzahlen der Motoren 10, 11 sowie die Übersetzungen der Zahnriemen 20, 22 zu berücksichtigen. Generell ist jedoch bei bekannten Getriebeübersetzungen die Hub- bzw. Absenkgeschwindigkeit des Ziehseiles 7 aus den Motordrehzahlen der beiden Motoren 10, 11 eindeutig berechenbar. Umgekehrt kann bei jeder Seildrehzahl die erforderliche Motordrehzahl des Ziehmotors 10 berechnet werden, um zu der gewünschten Hub- bzw. Absenkgeschwindigkeit des Ziehseiles 7 zu gelangen.

Um eine Verfolgung der vertikalen Absolutposition des Keimkristallhalters 6 zu erreichen, können die Achsen der Motoren 10, 11 mit je einem Inkrementalgeber verbunden werden. Die Anlagensteuerung ermittelt dann in festen Zeitintervallen die von den Motorwellen zurückgelegten Winkel und berechnet daraus jeweils den vom Keimkristallhalter 6 zurückgelegten Weg. Bei jedem Einschaltvorgang der Anlagensteuerung muss dann mit dem Seilhub eine Referenzfahrt zum Auffinden einer vertikalen Bezugsposition durchgeführt werden, wobei der Seilhub bis zum Erreichen eines Referenzschalters, beispielsweise einer Lichtschranke, durch den Keimkristallhalter 6 aktiviert wird.

### Bezugszeichenliste

| | |
|---|---|
| 1 | Kristall |
| 2 | Schmelze |
| 3 | Tiegel |
| 4 | Heizeinrichtung |
| 5 | Prozesskammer |
| | |
| 6 | Keimkristallhalter |
| 7 | Ziehseil |
| 8 | Seildrehknopf |
| 9 | Seiltrommel |
| 10 | Ziehmotor |
| | |
| 11 | Rotationsmotor |
| 12 | Schleifringe |
| 13 | Kabelkanal |
| 14 | Hohlwelle |
| 15 | Seilwickelmechanismus |
| | |
| 16 | Doppelzahnrad |
| 17 | Lagerung |
| 18 | Schleusenkammer |
| 19 | Wellendurchführung |
| 20 | Zahnriemen |
| | |
| 21 | zylindrisches Gehäuse |
| 22, 23 | Zahnriemen |
| 24 | Schneckenradgetriebe |
| 25 | Hilfwelle |
| 26 | Wellendurchführung |

## Patentansprüche

1. Kristallziehanlage mit einem Seildrehkopf, der mittels eines an der Kristallziehanlage ortsfest angeordneten Rotationsmotors um eine vertikale Drehachse drehbar ist, wobei im Seildrehkopf ein von einem Ziehmotor über ein Getriebe angetriebener Seilwickelmechanismus installiert ist, mit dem ein in der vertikalen Achse hängendes ziehseil vertikal bewegbar ist, **dadurch gekennzeichnet, dass** der ziehmotor (10) ebenfalls an der Kristallziehanlage ortsfest angeordnet ist und dass das Getriebe zwischen dem Ziehmotor (10) und dem Seilaufwickelmechanismus (15) ein Übertragungsglied aufweist, dessen Drehachse mit der vertikalen Drehachse des Seildrehkopfes (8) übereinstimmt.

2. Kristallziehanlage nach Anspruch 1, **dadurch gekennzeichnet, dass** eine Anlagensteuerung vorgesehen ist, die die Antriebsbewegung des Ziehmotors (10) so einstellt, dass der durch eine Drehung des Seildrehkopfes (8) induzierte Antrieb des Seilaufwickelmechanismus (15) und die damit verknüpfte vertikale Bewegung des Ziehseiles (7) kompensiert wird und eine der Anlagensteuerung mitgeteilte Hubgeschwindigkeit des Ziehseiles (7) erreicht wird.

3. Kristallziehanlage nach Anspruch 2, **dadurch gekennzeichnet, dass** beide Motoren (10, 11) mit je einem Inkrementalgeber gekoppelt sind, deren Signale der
Anlagensteuerung zur Verfügung gestellt werden.

4. Kristallziehanlage nach einem der vorhergehenden Ansprüche, **dadurch gekennzeichnet, dass** das Ziehseil (7) durch eine Hohlwelle (14) geführt ist, die den Seildrehkopf (8) trägt, und dass das Übertragungsglied drehbar auf der Hohlwelle (14) gelagert ist.

5. Kristallziehanlage nach einem der vorhergehenden Ansprizche, **dadurch gekennzeichnet, dass** das Übertragungsglied ein Doppelzahnrad (16) ist mit zwei übereinanderliegenden Verzahnungen, wobei das unter Zahnrad mit der Ausgangswelle (14) des ziehmotors und das ober Zahnrad mit einer Hilfswelle (25) des Seilaufwickelmechanismus (15) gekoppelt ist.

6. Kristallziehanlage nach Anspruch 5, **dadurch gekennzeichnet, dass** die Antriebsverbindung des Zahnrades mit der Ausgangswelle (14) bzw. mit der Antriebswelle jeweils einen Zahnriemen (20) aufweist.

7. Kristallziehanlage nach einem der Ansprüche 2 bis 6, **dadurch gekennzeichnet, dass** wenigstens ein Positionssensor zur Bestimmung des Seilhubes vorgesehen ist.

8. Kristallziehanlage nach Anspruch 7, **dadurch gekennzeichnet, dass** am Ende des ziehseils (7) ein Halter, insbesondere für Keimkristallhalter vorgesehen ist, und dass der Positionssensor als Positionsendschalter in der höchsten Position des Halters ausgebildet ist.

9. Kristallziehanlage nach Anspruch 8, **dadurch gekennzeichnet, dass** die Anlagensteuerung so eingerichtet ist, dass sie ausgehend von der höchsten Position des Halters, deren Erreichen mittels des Positionsendschalters festgestellt wird, und den Signalen der Inkrementalgeber, den jeweils aktuellen Hub des Halters zu ermitteln vermag.

10. Seildrehkopf für eine Kristallziehanlage, der mittels eines an der Kristallziehanlage ortsfest angeordneten Rotationsmotors um eine vertikale Drehachse drehbar ist, wobei im Seildrehkopf ein von einem Ziehmotor über ein Getriebe angetriebener Seilwickelmechanismus installiert ist, mit dem ein in der vertikalen Achse hängendes ziehseil vertikal bewegbar ist, **dadurch gekennzeichnet, dass** das Getriebe zwischen dem ziehmotor (10) und dem Seilaufwickelmechanismus (15) ein Übertragungsglied aufweist, dessen Drehachse mit der vertikalen Drehachse des Seildrehkopfes (8) übereinstimmt, so dass es möglich ist, den ziehmotor (10) an der Kristallziehanlage ortsfest anzuordnen.

11. Seildrehkopf nach Anspruch 10, **dadurch gekennzeichnet, dass** das Ziehseil (7) durch eine Hohlwelle (14) geführt ist, die den Seildrehkopf (8) trägt, und dass das Übertragungsglied drehbar auf der Hohlwelle (14) gelagert ist.

12. Seildrehkopf nach Anspruch 10 oder 11, **dadurch gekennzeichnet, dass** das Übertragungsglied ein Doppelzahnrad (16) ist mit zwei übereinanderliegenden Verzahnungen, wobei das unter Zahnrad mit der Ausgangswelle (14) des Ziehmotors und das ober Zahnrad mit einer Hilfswelle (25) des Seilaufwickelmechanismus (15) koppelbar ist.

13. Seildrehkopf nach Anspruch 12, **dadurch gekennzeichnet, dass** die Antriebsverbindung des Zahnrades mit der Ausgangswelle (14) bzw. mit der Antriebswelle jeweils einen Zahnriemen (20) aufweist.

## Claims

1. A crystal pulling system comprising a cable rotating head which is rotatable around a vertical axis of rotation by means of a rotation motor arranged stationarily on the crystal pulling system, wherein a cable winding mechanism driven by a pulling motor via a transmission is installed in the cable rotating head, by means of which cable winding mechanism a pulling cable suspended in the vertical axis is vertically movable, **characterized in that** the pulling motor (10) is also stationarily arranged on the crystal pulling system and that the transmission between the pulling motor (10) and the cable winding mechanism (15) has a transmission element, the axis of rotation of which corresponds to the vertical axis of rotation of the cable rotating head (8).

2. The crystal pulling system according to claim 1, **characterized in that** a system controller is provided which sets the drive movement of the pulling motor (10) in such a manner that the drive of the cable winding mechanism (15) induced by a rotation of the cable rotating head (8) and the vertical movement of the pulling cable (7) linked thereto are compensated, and a lift velocity of the pulling cable (7) communicated to the system controller is achieved.

3. The crystal pulling system according to claim 2, **characterized in that** both motors (10, 11) are coupled in each case to one incremental encoder, the signals of which are provided to the system controller.

4. The crystal pulling system according to any one of the preceding claims, **characterized in that** the pulling cable (7) is guided through a hollow shaft (14) which carries the cable rotating head (8), and that the transmission element is rotatably mounted on the hollow shaft (14).

5. The crystal pulling system according to any one of the preceding claims, **characterized in that** the transmission element is a double gearwheel (16) having two sets of teeth lying on top of each other, wherein the lower gearwheel is coupled to the output shaft (14) of the pulling motor and the upper gearwheel is coupled to an auxiliary shaft (25) of the cable winding mechanism (15).

6. The crystal pulling system according to claim 5, **characterized in that** the drive connection of the gearwheel to the output shaft (14) and/or the drive shafthas in each case a toothed belt (20).

7. The crystal pulling system according to any one of the claims 2 to 6, **characterized in that** at least one position sensor is provided for determining the cable lift.

8. The crystal pulling system according to claim 7, **characterized in that** a holder, in particular a holder for seed crystals, is provided at the end of the pulling cable (7), and that the position sensor is implemented as a position limit switch in the highest position of the holder.

9. The crystal pulling system according to claim 8, **characterized in that** the system controller is set in such a manner that it is capable of determining the respective current lift of the holder based on the highest position of the holder, wherein reaching the highest position is detected by means of the position limit switchand the signals of the incremental encoder.

10. A cable rotating head for a crystal pulling system which is rotatable around a vertical axis of rotation by means of a rotation motor arranged stationarily on the crystal pulling system, wherein a cable winding mechanism driven by a pulling motor via transmission is installed in the cable rotating head, by means of which cable winding mechanism a pulling cable suspended in the vertical axis is vertically movable, **characterized in that** the transmission between the pulling motor (10) and the cable winding mechanism (15) has a transmission element, the axis of rotation of which corresponds to the vertical axis of rotation of the cable rotating head (8) so that it is possible to stationarily arrange the pulling motor (10) on the crystal pulling system.

11. The cable rotating head according to claim 10, **characterized in** the pulling cable (7) is guided through a hollow shaft (14) which carries the cable rotating head (8), and that the transmission element is rotatably mounted on the hollow shaft (14).

12. The cable rotating head according to claim 10 or claim 11, **characterized in that** the transmission element is a double gearwheel (16) having two sets of teeth lying on top of each other, wherein the lower gearwheel can be coupled to the output shaft (14) of the pulling motor and the upper gearwheel can be coupled to an auxiliary shaft (25) of the cable winding mechanism (15).

13. The cable rotating head according to claim 12, **characterized in that** the drive connection of the gearwheel to the output shaft (14) and/or the drive shaft has in each case a toothed belt (20).

## Revendications

1. Installation de tirage de cristaux avec une tête rotative pour câble qui est rotative autour d'un axe de rotation vertical au moyen d'un moteur de rotation monté fixe sur l'installation de tirage de cristaux, un mécanisme d'enroulement de câble entraîné par un moteur de tirage via une transmission étant installé dans la tête rotative pour câble avec lequel un câble de tirage suspendu dans l'axe vertical peut être déplacé verticalement, **caractérisée en ce que** le moteur de tirage (10) est monté également fixe sur l'installation de tirage de cristaux et **en ce que** la transmission entre le moteur de tirage (10) et le mécanisme d'enroulement de câble (15) présente un élément de transmission dont l'axe de rotation coincide avec l'axe de rotation vertical de la tête rotative pour câble (8).

2. Installation de tirage de cristaux selon la revendication 1, **caractérisée en ce qu'**une commande d'installation est prévue qui règle le mouvement d'entraînement du moteur de tirage (10) de telle sorte que l'entraînement du mécanisme d'enroulement de câble (15) induit par une rotation de la tête rotative pour câble (8) et le mouvement verticale enchaîné de ce fait du câble de tirage (7) sont compensés et qu'une vitesse de levage communiquée à la commande d'installation du câble de tirage (7) est atteinte.

3. Installation de tirage de cristaux selon la revendication 2, **caractérisée en ce que** les deux moteurs (10, 11) sont chacun couplés à un capteur incrémentiel dont les signaux sont mis à la disposition de la commande d'installation.

4. Installation de tirage de cristaux selon une quelconque des revendications précédentes, **caractérisée en ce que** le câble de tirage (7) est guidé à travers un arbre creux (14) qui porte la tête rotative pour câble (8) et **en ce que** l'élément de transmission est monté pivotable sur l'arbre creux (14).

5. Installation de tirage de cristaux selon une quelconque des revendications précédentes, **caractérisée en ce que** l'élément de transmission est un engrenage double (16) avec deux dentures superposées, l'engrenage inférieur étant couplé avec l'arbre de sortie (14) du moteur de tirage et l'engrenage supérieur étant couplé avec un arbre intermédiaire (25) du mécanisme d'enroulement de câble (15).

6. Installation de tirage de cristaux selon la revendication 5, **caractérisée en ce que** la liaison d'entraînement de l'engrenage avec l'arbre de sortie (14) ou avec l'arbre d'entraînement présente à chaque fois une courroie dentée (20).

7. Installation de tirage de cristaux selon une quelconque des revendications 2 à 6, **caractérisée en ce qu'**au moins un capteur de position est prévu pour déterminer la course du câble.

8. Installation de tirage de cristaux selon la revendication 7, **caractérisée en ce qu'**à l'extrémité du câble de tirage (7) est prévu un support, en particulier un support de germe cristallin et **en ce que** le capteur de position est constitué comme capteur de fin de course de position dans la position maximale du support.

9. Installation de tirage de cristaux selon la revendication 8, **caractérisée en ce que** la commande d'installation est disposée de telle sorte qu'en partant de la position extrême du support, dont l'obtention est définie au moyen du capteur de fin de course de position, et des signaux de capteurs incrémentiels, il est possible de définir la course à chaque fois actuelle du support.

10. Tête rotative pour câble pour une installation de tirage de cristaux qui est rotative autour d'un axe de rotation vertical au moyen d'un moteur de rotation monté fixe sur l'installation de tirage de cristaux, un mécanisme d'enroulement de câble entraîné par un moteur de tirage via une transmission étant installé dans la tête rotative pour câble avec lequel un câble de tirage suspendu dans l'axe vertical peut être déplacé verticalement, **caractérisée en ce que** la transmission entre le moteur de tirage (10) et le mécanisme d'enroulement de câble (15) présente un élément de transmission dont l'axe de rotation coïncide avec l'axe de rotation vertical de la tête rotative pour câble (8) de sorte qu'il est possible de monter fixement le moteur de tirage (10) sur l'installation de tirage de cristaux.

11. Tête rotative pour câble selon la revendication 10, **caractérisée en ce que** le câble de tirage (7) est guidé à travers un arbre creux (14) qui porte la tête rotative pour câble (8) et **en ce que** l'élément de transmission est monté pivotable sur l'arbre creux (14).

12. Tête rotative pour câble selon la revendication 10 ou 11, **caractérisée en ce que** l'élément de transmission est un engrenage double (16) avec deux dentures superposées, l'engrenage inférieur étant couplé avec l'arbre de sortie (14) du moteur de tirage et l'engrenage supérieur avec un arbre intermédiaire (25) du mécanisme d'enroulement de câble (15).

13. Tête rotative pour câble selon la revendication 12, **caractérisée en ce que** la liaison d'entraînement de l'engrenage avec l'arbre de sortie (14) ou avec l'arbre d'entraînement présente à chaque fois une courroie dentée (20).
